# EUROPEAN PATENT SPECIFICATION

(11) **EP 1 235 233 B1**
(45) Date of publication and mention of the grant of the patent: **23.11.2005**
(21) Application number: 02076768.7
(22) Date of filing: 13.09.1994
(51) Int. Cl.: H01C 1/14, H01C 7/02, H01C 17/28

(54) **Circuit protection device, electrical assembly comprising it and method of making it**
Schaltungsschutzvorrichtung, elektrische Anordnung und Herstellungsverfahren
Dispositif de protection de circuit, assemblage électrique et procédé de fabrication

(30) Priority: 15.09.1993 US 121717
(43) Date of publication of application: 28.08.2002
(62) Divisional of application: 94928052.3
(73) Proprietor: TYCO Electronics Corporation, Middletown, PA 17057-3163 (US)
(72) Inventor: Fang, Shou-Mean, Yokahoma 236 (JP); Siden, Denis, Portola Valley, California 94028 (US); Thompson, Mark, San Carlos, California 94070 (US); Zhang, Michael, Hong Kong (CN)
(74) Representative: Jay, Anthony William

(56) References cited:
- DE-U- 8 716 103
- US-A- 3 775 725
- US-A- 4 486 737
- US-A- 4 689 475
- US-A- 4 924 074
- US-A- 4 977 309

## Description

This invention relates to circuit protection devices.

Many electrical devices comprise two laminar electrodes and, sandwiched between them, a laminar electrical element which may be a conductor, e.g. a resistive element, (as for example in a resistor or a varistor), or a non-conductor (as for example in a capacitor). Particularly useful devices of this type comprise a resistive element which exhibits PTC (positive temperature coefficient) behavior; in particular circuit protection devices which comprise two laminar electrodes and, sandwiched between the electrodes, a laminar resistive element which exhibits PTC behavior. The PTC resistive element may be composed of conductive polymer or a ceramic, e.g. a doped barium titanate. The term "conductive polymer" is used herein to denote a composition comprising a polymer and, dispersed (or otherwise distributed) therein, a particulate conductive filler.

US-A-4486737 discloses a low resistance ceramic PTC body having opposite poles, two opposite outer side surfaces being parallel to the longitudinal axis of the PTC body and two opposite end faces perpendicular to the outer side surfaces. The PTC body comprises rows of parallel depressions with partitions there between, the depressions having inner metallised surfaces at the opposite poles, metal layers disposed on the outer side surfaces, and metal strips disposed on the end faces interleaved in comb-fashion being connected to the metal layers.

In most such devices, an electrical lead is secured to each of the laminar electrodes, so that the device can be connected to other components of a circuit, e.g. mounted in apertures in a circuit board. The addition of leads is an additional expense and usually involves heating (e.g. during soldering or welding) which can cause damage (often manifested by a change in resistance), particularly to conductive polymer elements. The latter problem is particularly severe when a conductive polymer is heated a second time when the leads are connected to other circuit elements, in particular when the leads are connected to a printed circuit board by a soldering process. A further problem which can arise when such devices are to be mounted on a printed circuit board is that they protrude further from the board than is desirable.

We have now discovered, in accordance with the present invention, that in devices comprising a laminar electrical element between two electrodes, important advantages result from the presence of a transverse conductive member which passes through the electrical element and which is physically and electrically connected to one of the electrodes (the "first electrode"), but is not connected to the other electrode (the "second electrode") . The presence of such a transverse conductive member (often referred to herein as a "cross-conductor") makes it possible to make an electrical connection to the first electrode from the opposite side of the device. Furthermore, because the conductive member passes through the device, rather than around it, such devices can be made by processes in which the various operative steps are carried out on an assembly which corresponds to a plurality of devices and which, as the final step of the process, is divided into a plurality of devices. The ability to prepare devices in this way becomes increasingly important as the desired size (and, therefore, resistance) of the device decreases. This invention is, therefore, especially valuable for preparing devices which are to be mounted on circuit boards and in other situations in which the smaller the size and resistance of the device, the better. For example, this invention can be used to make circuit protection devices having a surface area of about 0.02 inch² (13 mm²) or even less.

This invention as defined by the features of claim 1 provides a circuit protection device.

The invention as defined by the features of claim 3 provides a structure which (if necessary after further processing) can be divided into a plurality of circuit protection devices, each of the devices containing at least one cross-conductor.

In another preferred aspect, this invention is defined by the features of claim 6.

In another preferred aspect, this invention provides a method of making circuit protection devices which is defined by the features of claim 7.

When the PTC material is a conductive polymer, this method preferably makes use of a novel assembly which forms part of the present invention, namely an assembly which comprises
(1) a laminar PTC resistive element which (i) is composed of a conductive polymer exhibiting PTC behavior, and (ii) has a first face and a second face,
(2) a first laminar conductive member which is secured to the first face of the PTC element, and
(3) a second laminar conductive member which is secured to the second face of the PTC element;
the PTC element and the first and second laminar conductive members defining a plurality of apertures which pass through the thickness of the assembly, and the apertures being arranged in a regular pattern.

In this assembly, preferably
(a) the apertures are arranged in a plurality of straight lines, and
(b) the first laminar conductive member is in the form of a plurality of strips which are parallel to each other and to the lines of apertures.

It is particularly preferred that
(a) each strip of the first conductive member contains two adjacent lines of apertures, and
(b) the second laminar conductive member is also in the form of a plurality of strips which are parallel to each other and to the lines of apertures, with each strip containing two adjacent lines of apertures, one of said lines of apertures falling within a first strip of the first conductive member and the other line of apertures falling within a second strip of the first conductive member.

The invention is described below chiefly by reference to PTC circuit protection devices which comprise a laminar PTC element composed of a PTC conductive polymer and two laminar electrodes secured directly to the PTC element, and to the production of such devices. It is to be understood, however, that the description is also applicable, insofar as the context permits, to other electrical devices containing PTC conductive polymer elements, to electrical devices containing PTC ceramic elements, and to other electrical devices comprising two laminar electrodes with a laminar electrical element between them.

As described and claimed below the present invention can make use of a number of particular features. Where such a feature is disclosed in a particular context or as part of a particular combination, it can also be used in other contexts and in other combinations, including for example other combinations of two or more such features.

### PTC Compositions

The PTC compositions used in the present invention are preferably conductive polymers which comprise a crystalline polymer component and, dispersed in the polymer component, a particulate filler component which comprises a conductive filler, e.g. carbon black or a metal. The filler component may also contain a nonconductive filler, which changes not only the electrical properties of the conductive polymer but also its physical properties. The composition can also contain one or more other components, e.g. an antioxidant, crosslinking agent, coupling agent or elastomer. For use in circuit protection devices, the PTC composition preferably has a resistivity at 23~C of less than 50 ohm-cm, particularly less than 10 ohm-cm, especially less than 5 ohm-cm. Suitable conductive polymers for use in this invention are disclosed for example in U.S. Patent Nos. 4,237,441, 4,304,987, 4,388,607, 4,514,620, 4,534,889, 4,545,926, 4,560,498, 4,591,700, 4,724,417, 4,774,024, 4,935,156, and 5,049,850.

The PTC resistive element is preferably a laminar element, and can be composed of one or more conductive polymer members, at least one of which is composed of a PTC material. When there is more than one conductive polymer member, the current preferably flows sequentially through the different compositions, as for example when each composition is in the form of a layer which extends across the whole device. When there is a single PTC composition, and the desired thickness of the PTC element is greater than that which can conveniently be prepared in a single step, a PTC element of the desired thickness can conveniently be prepared by joining together, e.g. laminating by means of heat and pressure, two or more layers, e.g. melt-extruded layers, of the PTC composition. When there is more than one PTC composition, the PTC element will usually be prepared by joining together, e.g. laminating by means of heat and pressure, elements of the different compositions. For example, a PTC element can comprise two laminar elements composed of a first PTC composition and, sandwiched between them, a laminar element composed of a second PTC composition having a higher resistivity than the first.

When a PTC device is tripped, most of the voltage dropped over the device is normally dropped over a relatively small part of the device which is referred to as the hot line, hot plane or hot zone. In the devices of the invention, the PTC element can have one or more features which help the hot line to form at a desired location, usually spaced apart from both electrodes. Suitable features of this kind for use in the present invention are disclosed for example in U.S. Patents Nos. 4,317,027, 4,352,083, 4,907,340 and 4,924,072.

### Laminar Electrodes

Particularly useful devices of the invention comprise two metal foil electrodes, and a PTC conductive polymer element sandwiched between them, especially such devices which are used as circuit protection devices and have low resistance at 23°C, generally less than 50 ohm, preferably less than 15 ohm, more preferably less than 10 ohm, particularly less than 5 ohm, especially less than 3 ohm. Particularly suitable foil electrodes are microrough metal foil electrodes, including in particular electrodeposited nickel foils and nickel-plated electrodeposited copper foil electrodes, in particular as disclosed in U.S. Patents Nos. 4,689,475 and 4,800,253. A variety of laminar devices which can be modified in accordance with the present invention are disclosed in U.S. Patent Nos. 4,238,812, 4,255,798, 4,272,471, 4,315,237, 4,317,027, 4,330,703, 4,426,633, 4,475,138, 4,724,417, 4,780,598, 4,845,838, 4,907,340, and 4,924,074. The electrodes can be modified so as to produce desired thermal effects.

### Apertures and Cross-Conductors

The term "aperture" is used herein to denote an opening which
(a) has a closed cross section, e.g. a circle, an oval, or a generally rectangular shape, or
(b) has an open reentrant cross section which (i) has a depth at least 0.15 times, preferably at least 0.5 times, particularly at least 1.2 times, the maximum width of the cross section, e.g. a quarter circle or a half circle or an open-ended slot, and/or (ii) has at least one part where the opposite edges of the cross section are parallel to each other.

In assemblies of the invention which can be divided into a plurality of electrical devices, the apertures will normally be of closed cross section, but if one or more of the lines of division passes through an aperture of closed cross section, then the apertures in the resulting devices will then have open cross sections. It is important that any such open cross section is a reentrant cross section as defined above, in order to ensure that the cross-conductor is not damaged or dislodged during installation or use of the device.

The aperture can be a circular hole, and for many purposes this is satisfactory in both individual devices and assemblies of devices. However, if the assembly includes apertures which are traversed by at least one line of division, elongate apertures may be preferred because they require less accuracy in the lines of division.

When the aperture is not traversed by a line of division, it can be as small as is convenient for a cross-conductor having the necessary current-carrying capacity. For circuit protection devices, holes of diameter 0.1 to 5 mm, preferably 0.15 to 1.0 mm, e.g. 0.2 to 0.5 mm, are generally satisfactory. Generally a single cross-conductor is all that is needed to make an electrical connection to the first electrode from the opposite side of the device. However, two or more cross-conductors can be used to make the same connection. The number and size of the cross-conductors, and, therefore, their thermal capacity, can have an appreciable influence on the rate at which a circuit protection device will trip.

The aperture can be formed before the cross-conductor is put in place, or the formation of the aperture and the placing of the cross-conductor can be carried out simultaneously. A preferred procedure is to form the aperture, e.g. by drilling, slicing or any other appropriate technique, and then to plate or otherwise coat or fill the interior surface of the aperture. The plating can be effected by electroless plating, or electrolytic plating, or by a combination of both. The plating can be a single layer or multiple layers, and can be composed of a single metal or a mixture of metals, in particular a solder. The plating will often also be formed on other exposed conductive surfaces of the assembly. If such plating is not desired, then the other exposed conductive surfaces must be masked or otherwise desensitized. Generally, however, the plating is carried out at a stage of the process at which such additional plating will not produce an adverse effect. The invention includes the possibility that the plating will produce not only the cross-conductor but also at least part of the laminar conductive members in the device.

The plating techniques which are used for making conductive vias through insulating circuit boards can be used in the present invention. However, in this invention the plating serves merely to convey current across the device, whereas a plated via must make good electrical contact with another component. Consequently, the plating quality required in this invention may be less than that required for a via.

Another technique for providing the cross-conductors is to place a moldable or liquid conductive composition in preformed apertures, and if desired 9r necessary to treat the composition, while it is in the apertures, so as to produce cross-conductors of desired properties. The composition can be supplied selectively to the apertures, e.g. by means of a screen, or to -the whole assembly, if desired after pretreating at least some of the assembly so that the composition does not stick to it. For example, a molten conductive composition, e.g. solder, could be used in this way, if desired using wave soldering techniques; and apertures in a PTC ceramic element could be filled with a conductive ceramic paste which was fired or otherwise consolidated in situ.

The cross-conductor can also be provided by a preformed member, e.g. a metal rod or tube, for example a rivet. When such a preformed member is used, it can create the aperture as it is put in place in the device.

The cross-conductor can partially or completely fill the aperture. When the aperture is partially filled, it can be further filled (including completely filled) during the process in which the device is connected to other electrical components, particularly by a soldering process. This can be encouraged by providing additional solder in and around the aperture, especially by including a plating of solder in and around the aperture. Normally at least a part of the cross-conductor will be put in place before the device is connected to other electrical components. However, the invention includes the possibility that the cross-conductor is formed during such a connection process, as for example by the capillary action of solder during a soldering process.

### Assemblies

As briefly noted above, the assemblies of the invention include both devices which are ready for connection to other electrical components and structures which (if necessary after further processing) can be divided into a plurality of electrical devices.

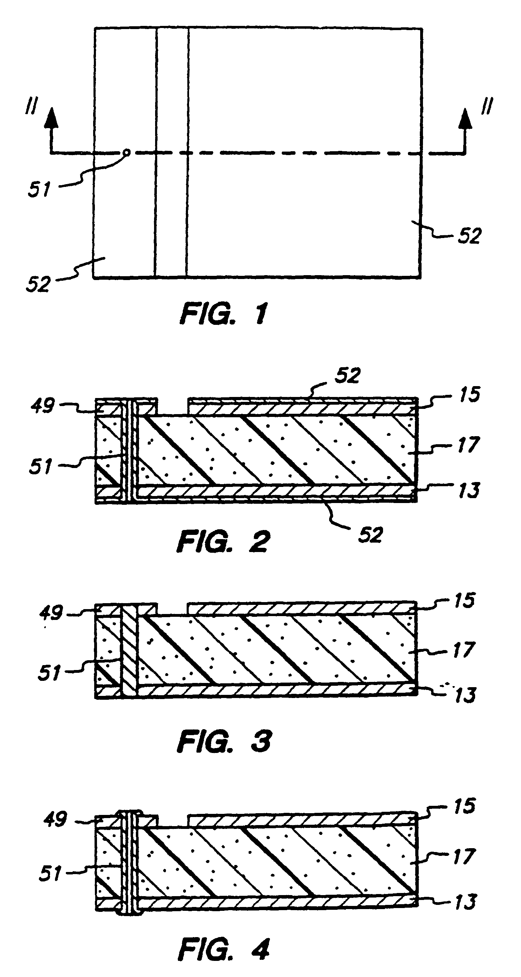

In the devices which are ready for connection, the "first laminar conductive member" (to which the cross-conductor is physically and electrically connected) provides the first electrode, and the device generally also includes a second laminar conductive member which is not connected to the first electrode or the cross-conductor and which provides the second electrode. The first and second electrodes are generally secured, directly or indirectly, to opposite faces of a laminar PTC element, and the current-carrying part of the PTC element is that part which lies between the two electrodes. Preferably the device also includes a third laminar conductive member which (a) is secured to the second face of the PTC element in the area, of the aperture, (b) is electrically connected to the cross-conductor, and (c) is spaced apart from the second electrode. Thus this third member provides a conductive pad through which connection can be made to the first electrode (via the cross-conductor) and which is easier to make a connection to than the cross-conductor alone. This third member is preferably a residual member formed by removing a part of a laminar conductive member, in particular from one laminar conductive member of an assembly comprising two laminar conductive members and a PTC element between them; the other part of the conductive member provides the second electrode. The shape of the third member, and of the gap between the third member and the second electrode, can be varied to suit the desired characteristics of the device and for ease of manufacture. Thus the third member is conveniently a small rectangle at one end of a rectangular device, separated from the second electrode by a rectangular gap, as shown for example in Figures 1 and 2; but other arrangements are possible. For example the third member can be an island separated from the second electrode by a gap of closed cross section. If two or more devices in parallel are needed, there can be two or more second electrodes on the second face of the PTC element, with a single first electrode which is on the first face of the PTC element and to which connection is made via the cross-conductor. When two or more devices in series are required, the third member of one device can be connected to the second electrode of the adjacent device; the devices can be joined together by noncurrent-carrying sections of the PTC conductive polymer element, or otherwise.

In the simplest devices, there is a single first electrode, a single cross-conductor, a single third member, and a single second electrode. Such a device which is not an embodiment of the invention is illustrated in Figures 1 and 2. A disadvantage of such a device is that it must be placed on the circuit board the right way up. This disadvantage can be overcome (at the expense of additional material and processing costs) by making a device which has two third members (one associated with each electrode) and two cross-conductors (one associated with each third member) . Such a device is illustrated in Figures 5 and 6.

The devices of the invention which are ready for connection can be of any appropriate size. However, it is an important advantage of the invention that very small devices can be easily prepared. Preferred devices of the invention have a maximum dimension of at most 12 mm, preferably at most 7 mm, and/or a surface area of at most 30 mm², preferably at most 20 mm², especially at most 15 mm².

In the assemblies of the invention which, if necessary after further processing, can be divided into a plurality of devices, preferably
(a) the PTC resistive element defines a plurality of the apertures running between the first and second faces of the PTC element,
(b) there are a plurality of the transverse conductive members, each of the transverse members lying within one of the apertures, and
(c) the apertures and the transverse members are arranged in a regular pattern.

Generally the assembly further comprises
(3) a first laminar conductive member which (a) is secured to the first face of the PTC element, and (b) is physically and electrically connected to all the transverse members; and
(4) a second laminar conductive member which is secured to the second face of the PTC element.
The transverse members is also physically and electrically connected to a second laminar conductive member. The first and/or second conductive members, before the assembly is divided and before or after the transverse members are put in place, are preferably in the form of a plurality of strips, arranged so that the assembly can be divided, along lines parallel to the strips, into devices which comprise first and second electrodes and a third member which is on the same face of the PTC element as the second electrode but is not connected to the second electrode.

### Processes

The devices of the invention can be prepared in any way. However, the preferred methods of the invention make it possible to prepare devices very economically by carrying out all or most of the process steps on a large laminate, and then dividing the laminate into a plurality of individual devices, or into relatively small groups of devices which are connected together physically and which may be connected to each other electrically, in series or in parallel or both. The division of the laminate can be carried out along lines which pass through one or both or neither of the laminar conductive members or through none, some or all of the cross-conductors. The process steps prior to division can in general be carried out in any convenient sequence.

The accompanying drawings help for a better understanding of the invention, in which the size of the apertures and the thicknesses of the components have been exaggerated in the interests of clarity. Figure 1 is a plan view of a circuit protection device, and Figure 2 is a cross section on line II-II of Figure 1. The device includes a laminar PTC element 17 having a first face to which first laminar electrode 13 is attached and a second face to which second laminar electrode 15 is attached. Also attached to the second face is an additional laminar conductive member 49 which is not electrically connected to electrode 15. Cross-conductor 51 lies within an aperture defined by first electrode 13, PTC element 17 and additional member 49. The cross-conductor is a hollow tube formed by a plating process which also results in a plating 52 on the surfaces of the device which were exposed during the plating process.

Figures 3 and 4 are similar to Figure 2 but show cross-conductors which are in the form of a metal rod (Figure 3) or a rivet (Figure 4).

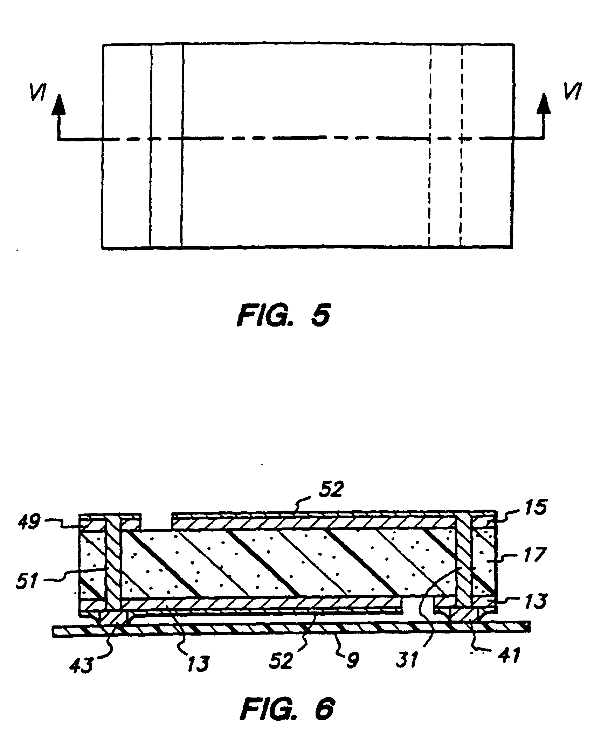

Figure 5 is a plan view of another circuit protection device which has been soldered to a circuit board, and Figure 6 is a cross section on line VI-VI of Figure 5. The device is similar to that shown in Figures 1 and 2 but has been made symmetrical so that it can be placed on a circuit board either way up. Thus the device includes a second cross-conductor 31 which connects the second electrode 15 to a second additional member 35. The cross-conductors were made by plating the apertures (and the other exposed surfaces) first with copper and then with solder. The device has been soldered to traces 41 and 43 on an insulating substrate 9. During the soldering process the solder plating on the device flows and completely fills the apertures.

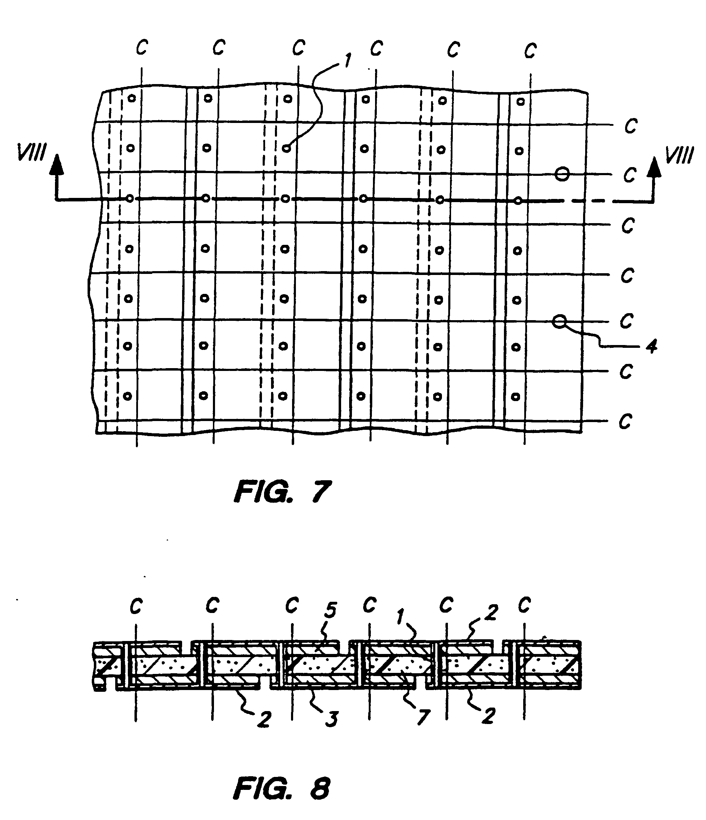

Figure 7 is a plan view of a part of an assembly which can be divided into a number of individual devices as shown in Figures 1 and 2, and Figure 8 is a cross section on line VIII-VIII of Figure 7. The assembly includes a laminar PTC element 7 having a first face to which first laminar conductive member 3 is attached and a second face to which second laminar conductive member 5 is attached. The conductive members 3 and 5 are not continuous but are in the form of parallel strips formed by removing, e.g. by etching, strips of electrode material from a corresponding continuous member. The material is removed in staggered strips alternately from opposite sides of the assembly, in order to balance the physical stresses in the product. Before the etching step, a plurality of holes, arranged in a regular pattern, have been drilled through the PTC element 7 and the laminar members 3 and 5, and the assembly has then been plated to provide a tubular cross-conductor 1 in each of the apertures (and a plating 2 on other exposed surfaces of the assembly) . The assembly can be converted into a plurality of devices by dividing it along the lines marked C. At the edge of the assembly, there are registration holes 4 for use in locating the holes to be drilled through the element 7 and members 3 and 5, and in locating the lines of division C.

The invention is illustrated by the following Example.

### Example

A conductive polymer composition was prepared by pre blending 48.6% by weight high density polyethylene (Petrothene™ LB 832, available from USI) with 51.4% by weight carbon black (Raven™ 430, available from Columbian Chemicals), mixing the blend in a Banbury™ mixer, extruding the mixed compound into pellets, and extruding the pellets though a 3.8 cm (1.5 inch) extruder to produce a sheet with a thickness of 0.25 mm (0.010 inch). The extruded sheet was cut into 0.31 x 0.41 meter (12 x 16 inches) pieces and each piece was stacked between two sheets of 0.025 mm (0.001 inch) thick electrodeposited nickel foil (available from Fukuda). The layers were laminated under heat and pressure to form a plaque with a thickness of about 0.25 mm (0.010 inch)-. Each plaque was irradiated to 10 Mrad. Each plaque was used to prepare approximately 7000 devices, each having the configuration shown in Figures 1 and 2.

Holes with a diameter of 0.25 mm (0.010 inch) were drilled through the thickness of the plaque in a regular pattern to provide one hole for each device. Each hole was deburred and cleaned. The surface of both the nickel foil layers and the conductive polymer surrounding the drilled hole were sensitized using a palladium/copper solution. A copper layer approximately 0.076 mm (0.003 inch) thick was electroless plated onto the sensitized surfaces and then a 0.025 mm (0.001 inch) thick layer of tin-lead solder was electroless plated onto the copper surface. Using the following standard photoresist process, a pattern was etched onto the plaque. First, a dry film (Mylar™ polyester) resist was laminated onto both surfaces of the plaque and then exposed to ultraviolet light to generate a pattern as shown in Figures 7 and 8. Second, a ferric chloride solution was used to chemically etch the pattern. During this step, alternating sections on each side of the plaque were etched away to expose the solder and relieve built-up mechanical stress. Third, the etched plaque was rinsed and the resist was stripped away.

The plaque was sheared and diced to produce individual rectangular electrical devices. Each device had dimensions of 4.57 x 3.05 x 0.51 mm (0.180 x 0.120 x 0.020 inch). The through-hole was positioned approximately 3.81 mm (0.015 inch) from the shorter edge of the device. A strip of exposed conductive polymer 0.51 x 3.05 mm (0.020 x 0.120 inch) was present 0.38 mm (0.015 inch) from the through-hole and 1.02 mm (0.040 inch) from the shorter edge of the device. Each device had a resistance of approximately 300 mohm.

## Claims

1. A circuit protection device which comprises
(1) a laminar PTC resistive element (17) which (a) is composed of a conductive polymer which exhibits PTC behavior, (b)has a first face and a second face, and (c) defines an aperture which runs between the first and second faces;
(2) a transverse conductive member (51) which (a) lies within the aperture defined by the PTC element, (b) runs between the first and second faces of the PTC element, and (c) is secured to the PTC element;
(3) a first laminar electrode (13) which (a) is secured to the first face of the PTC element and (b) is physically and electrically connected to the transverse conductive member; and
(4) a second laminar electrode (15) which is secured to the second face of the PTC element and which is not electrically connected to the transverse conductive member.

2. A circuit protection device according to claim 1 wherein the transverse conductive member (51) comprises at least one of
(a) a plating of metal on the surface of the PTC element which defines the aperture,
(b) solder, and
(c) a preformed metal rod or tube.

3. A structure which can be divided into a plurality of the said circuit protection devices of claim 1 and wherein
(a) the PTC resistive element (7) defines a plurality of apertures running between the first and second faces of the PTC element,
(b) there are a plurality of the transverse conductive members, each of the transverse members lying within one of the apertures, and
(c) the apertures and the transverse members are arranged in a regular pattern.

4. A structure according to Claim 3 wherein the PTC element is a laminar element composed of a conductive polymer, wherein a first laminar conductive member (a) is secured to the first face of the PTC element and (b) is physically and electrically connected to all the transverse members; and the structure further comprises
a second laminar conductive member which is secured to the second face of the PTC element.

5. A structure according to Claim 4 wherein each of the first and second laminar conductive members consists of a plurality of parallel strips.

6. An electrical assembly which comprises
(A) a printed circuit board (9) including first and second conductive traces (41,43) on a surface thereof, and
(B) an electrical device which comprises
(1) a laminar PTC resistive element (17) which (a) is composed of a resistive material which exhibits PTC behavior, (b) has a first face and a second face, and (c) defines an aperture which runs between the first and second faces;
(2) a first laminar electrode (13) which is secured to the first face of the PTC element;
(3) a second laminar electrode (15) which is secured to the second face of the PTC element; and
(4) a transverse conductive-member which
(a) lies within the aperture, and
(b) is physically and electrically connected to the first electrode and is not electrically connected to the second electrode
said electrical device being placed on the printed circuit board and parallel thereto, with the first conductive trace physically and electrically connected to the transverse conductive member, and the second conductive trace physically and electrically connected to the second electrode.

7. A method of making a plurality of circuit protection devices according to claim 1 which comprises
(A) providing a structure which comprises
(1) a laminar PTC resistive element (7) which (i) is composed of a resistive material exhibiting PTC behavior, and (ii) has a first face and a second face,
(2) a first laminar conductive member (3) which is secured to the first face of the PTC element, and
(3) a second laminar conductive member (5) which is secured to the second face of the PTC element;
(B) making a plurality of apertures through the thickness of the assembly provided in step (A), the apertures being arranged in a regular pattern;
(C) simultaneously with step (B), or after step (B), placing a plurality of transverse conductive members (1) within the apertures, in electrical contact with the first laminar conductive member;
(D) removing predetermined portions of at least one of the first and second conductive members; and
(E) after steps (A) to (D), dividing the assembly into a plurality of circuit protection devices, each device comprising
(1) a part of the PTC resistive element,
(2) a part of the first laminar conductive member, said part providing a first electrode in some of the devices and a second electrode in the other devices,
(3) a part of the second laminar conductive member, said part providing a second electrode in some of the devices and a first electrode in the other devices, and
(4) at least one transverse conductive member which is electrically connected to the first electrode.

## Patentansprüche

1. Schaltungsschutzvorrichtung, umfassend:
(1) ein laminares PTC-Widerstandselement (17), das (a) aus einem leitenden Polymer besteht, das ein PTC-Verhalten zeigt, (b) eine erste Seite und eine zweite Seite aufweist und (c) eine Öffnung definiert, die zwischen der ersten und der zweiten Seite verläuft;
(2) ein transversales leitendes Element (51), das (a) in der Öffnung liegt, die durch das PTC-Element definiert wird, (b) zwischen der ersten und der zweiten Seite des PTC-Elementes verläuft und (c) am PTC-Element befestigt ist;
(3) eine erste laminare Elektrode (13), die (a) an der ersten Seite des PTC-Elementes befestigt ist und (b) mit dem transversalen leitenden Element physikalisch und elektrisch verbunden ist; und
(4) eine zweite laminare Elektrode (15), die an der zweiten Seite des PTC-Elementes befestigt ist und die nicht mit dem transversalen leitenden Element elektrisch verbunden ist.

2. Schaltungsschutzvornchtung nach Anspruch 1, bei der das transversale leitende Element (51) mindestens eines von Folgendem umfasst:
(a) eine Metallisierung auf der Oberfläche des die Öffnung definierenden PTC-Elementes,
(b) Lot,
(c) einen vorgeformten Metallstab oder ein vorgeformtes Metallrohr.

3. Struktur, die sich in eine Vielzahl der Schaltungsschutzvorrichtungen nach Anspruch 1 unterteilen lässt und bei der
(a) das PTC-Widerstandselement (7) eine Vielzahl von Öffnungen definiert, die zwischen der ersten und der zweiten Seite des PTC-Elementes verlaufen,
(b) eine Vielzahl der transversalen leitenden Elemente vorhanden sind, wobei jedes der transversalen Elemente in einer der Öffnungen liegt, und
(c) die Öffnung und die transversalen Elemente in einem regelmäßigen Muster angeordnet sind.

4. Struktur nach Anspruch 3, bei der das PTC-Element ein laminares Element ist, das aus einem leitenden Polymer besteht, wobei ein erstes laminares leitendes Element (a) an der ersten Seite des PTC-Elementes befestigt ist und (b) mit allen transversalen Elementen physikalisch und elektrisch verbunden ist; und die Struktur außerdem Folgendes umfasst:
ein zweites laminares leitendes Element, das an der zweiten Seite des PTC-Elementes befestigt ist.

5. Struktur nach Anspruch 4, bei der jedes der ersten und der zweiten laminaren leitenden Elemente aus einer Vielzahl von parallelen Streifen besteht.

6. Elektrische Baugruppe, umfassend:
(A) eine Leiterplatte (9), die eine erste und eine zweite leitende Leiterbahn (41, 43) auf einer Oberfläche derselben umfasst, und
(B) eine elektrische Vorrichtung, die Folgendes umfasst:
(1) ein laminares PTC-Widerstandselement (17), das (a) aus einem Widerstandsmaterial besteht, das ein PTC-Verhalten zeigt, (b) eine erste Seite und eine zweite Seite aufweist und (c) eine Öffnung definiert, die zwischen der ersten und der zweiten Seite verläuft;
(2) eine erste laminare Elektrode (13), die an der ersten Seite des PTC-Elementes befestigt ist;
(3) eine zweite laminare Elektrode (15), die an der zweiten Seite des PTC-Elementes befestigt ist; und
(4) ein transversales leitendes Element, das
(a) in der Öffnung liegt und
(b) mit der ersten Elektrode physikalisch und elektrisch verbunden ist und mit der zweiten Elektrode nicht elektrisch verbunden ist;
wobei die elektrische Vorrichtung auf der Leiterplatte und parallel zu derselben angeordnet ist, wobei die erste leitende Leiterbahn mit dem transversalen leitenden Element physikalisch und elektrisch verbunden ist und die zweite leitende Leiterbahn mit der zweiten Elektrode physikalisch und elektrisch verbunden ist.

7. Verfahren zur Herstellung einer Vielzahl von Schaltungsschutzvorrichtungen nach Anspruch 1, das Folgendes umfasst:
(A) Bereitstellen einer Struktur, die Folgendes umfasst:
(1) ein laminares PTC-Widerstandselement (7), das (i) aus einem Widerstandsmaterial besteht, das ein PTC-Verhalten zeigt und (ii) eine erste Seite und eine zweite Seite aufweist;
(2) ein erstes laminares leitendes Element (3), das an der ersten Seite des PTC-Elementes befestigt ist; und
(3) ein zweites laminares leitendes Element, das an der zweiten Seite des PTC-Elementes befestigt ist;
(B) Herstellen einer Vielzahl von Öffnungen durch die Dicke der in Schritt (A) bereitgestellten Baugruppe, wobei die Öffnungen in einem regelmäßigen Muster angeordnet sind;
(C) gleichzeitig mit Schritt (B), oder nach Schritt (B), Anordnen einer Vielzahl von transversalen leitenden Elementen (1) in den Öffnungen, in elektrischem Kontakt mit dem ersten laminaren leitenden Element;
(D) Entfernen von vorgegebenen Teilen von mindestens einem Element des ersten und des zweiten leitenden Elementes; und
(E) nach Schritt (A) bis (D), Unterteilen der Baugruppe in eine Vielzahl von Schaltungsschutzvorrichtungen, wobei jede Vorrichtung Folgendes umfasst:
(1) einen Teil des PTC-Widerstandselementes;
(2) einen Teil des ersten laminaren leitenden Elementes, wobei der Teil eine erste Elektrode in einigen der Vorrichtungen und eine zweite Elektrode in den anderen Vorrichtungen bereitstellt;
(3) einen Teil des zweiten laminaren leitenden Elementes, wobei der Teil eine zweite Elektrode in einigen der Vorrichtungen und eine erste Elektrode in den anderen Vorrichtungen bereitstellt; und
(4) mindestens ein transversales leitendes Element, das mit der ersten Elektrode elektrisch verbunden ist.

## Revendications

1. Dispositif de protection de circuit comprenant
(1) un élément résistif CTP laminaire (17) qui (a) est formé d'un polymère conducteur ayant un comportement CTP, (b) possède une première face et une seconde face et (c) définit une ouverture qui s'étend entre les première et seconde faces;
(2) un élément conducteur transversal (51) qui (a) est situé à l'intérieur de l'ouverture définie par l'élément CTP, (b) s'étend entre les première et seconde faces de l'élément CTP et (c) est fixé sur l'élément CTP;
(3) une première électrode laminaire (13) qui (a) est fixée sur la première face de l'élément CTP et (b) est connectée physiquement et électriquement à l'élément conducteur transversal; et
(4) une seconde électrode laminaire (15) qui (a) est fixée sur la seconde face de l'élément CTP et n'est pas connectée électriquement à l'élément conducteur transversal.

2. Dispositif de protection de circuit selon la revendication 1, dans lequel l'élément conducteur transversal (51) comprend au moins un élément parmi
(a) un placage de métal sur la surface de l'élément CTP qui définit l'ouverture,
(b) de l'étain à braser et
(c) une tige ou un tube métallique préformé(e).

3. Structure pouvant être divisée en une pluralité desdits dispositifs de protection de circuit de la revendication 1 et dans laquelle
(a) l'élément résistif CTP (7) définit une pluralité d'ouvertures s'étendant entre les première et seconde faces de l'élément CTP,
(b) il y a une pluralité d'éléments conducteurs transversaux, chacun des éléments transversaux étant situé à l'intérieur de l'une des ouvertures et
(c) les ouvertures et les éléments transversaux sont disposés suivant un motif régulier.

4. Structure selon la revendication 3, dans laquelle l'élément CTP est un élément laminaire formé d'un polymère conducteur, dans laquelle un premier élément conducteur laminaire (a) est fixé sur la première face de l'élément CTP et (b) est connecté physiquement et électriquement à tous les éléments transversaux; et la structure comprend, en outre,
un second élément conducteur laminaire qui est fixé sur la seconde face de l'élément CTP.

5. Structure selon la revendication 4, dans laquelle chacun des premier et second éléments conducteurs laminaires est formé d'une pluralité de bandes parallèles.

6. Assemblage électrique comprenant
(A) une carte à circuit imprimé (9) incluant un premier et un second rubans conducteurs (41, 43) sur une de ses surfaces et
(B) un dispositif électrique comprenant
(1) un élément résistif CTP laminaire (17) qui (a) est formé d'un matériau résistif ayant un comportement CTP, (b) possède une première face et une seconde face et (c) définit une ouverture qui s'étend entre les première et seconde faces;
(2) une première électrode laminaire (13) qui est fixée sur la première face de l'élément CTP;
(3) une seconde électrode laminaire (15) qui est fixée sur la seconde face de l'élément CTP; et
(4) un élément conducteur transversal qui
(a) est situé à l'intérieur de l'ouverture et
(b) est connecté physiquement et électriquement à la première électrode et n'est pas connecté électriquement à la seconde électrode,
ledit dispositif électrique étant placé sur la carte à circuit imprimé, parallèlement à cette dernière, avec le premier ruban conducteur connecté physiquement et électriquement à l'élément conducteur transversal et le second ruban conducteur connecté physiquement et électriquement à la seconde électrode.

7. Procédé de fabrication d'une pluralité de dispositifs de protection de circuit selon la revendication 1, comprenant les étapes consistant à
(A) fournir une structure comprenant
(1) un élément résistif CTP laminaire (7) qui (i) est formé d'un matériau résistif ayant un comportement CTP et (ii) possède une première et une seconde faces,
(2) un premier élément conducteur laminaire (3) qui est fixé sur la première face de l'élément CTP et
(3) un second élément conducteur laminaire (5) qui est fixé sur la seconde face de l'élément CTP;
(B) former une pluralité d'ouvertures à travers l'épaisseur de l'assemblage fourni dans l'étape (A), les ouvertures étant disposées suivant un motif régulier;
(C) simultanément à l'étape (B), ou après l'étape (B), placer une pluralité d'éléments conducteurs transversaux (1) à l'intérieur des ouvertures, en contact électrique avec le premier élément conducteur laminaire;
(D) enlever des parties prédéterminées d'au moins un des premier et second éléments conducteurs; et
(E) après les étapes (A) à (D), diviser l'assemblage en une pluralité de dispositifs de protection de circuit, chaque dispositif comprenant
(1) une partie de l'élément résistif CTP,
(2) une partie du premier élément conducteur laminaire, ladite partie fournissant une première électrode dans certains des dispositifs et une seconde électrode dans les autres dispositifs,
(3) une partie du second élément conducteur laminaire, ladite partie fournissant une seconde électrode dans certains des dispositifs et une première électrode dans les autres dispositifs et
(4) au moins un élément conducteur transversal qui est connecté électriquement à la première électrode.
